**Europäisches Patentamt**

**European Patent Office**

**Office européen des brevets**

(19)

(11) Numéro de publication: **0 031 033**
A1

## (12) DEMANDE DE BREVET EUROPEEN

(21) Numéro de dépôt: **80107167.1**

(22) Date de dépôt: **18.11.80**

(51) Int. Cl.³: **G 09 F 9/37**
//A63B71/06

(30) Priorité: **11.12.79 IT 4402579**

(43) Date de publication de la demande:
**01.07.81 Bulletin 81/26**

(84) Etats Contractants Désignés:
**DE FR GB**

(71) Demandeur: **Tamburini, Carlo**
**4, Rue de Amicis**
**I-61032 Fano (Pesaro)(IT)**

(72) Inventeur: **Tamburini, Carlo**
**4, Rue de Amicis**
**I-61032 Fano (Pesaro)(IT)**

(74) Mandataire: **Maschio, Stefano**
**44, Rue Milite Ignoto**
**I-61100 Pesaro(IT)**

(54) **Dispositif pour la composition et pour la visualisation de chiffres qui peuvent être formés et effacés à discrétion manuellement et rapidement.**

(57) Le dispositif est constitué par un panneau comprenant des rouleaux disposés de façon adéquate; chaque rouleau est divisé longitudinalement en deux parties d'une couleur différente et contrastante. Une de ces deux parties a la même couleur que le panneau de fond.

Chaque rouleau on peut le faire pivoter par l'effleurement d'une main de façon à présenter vers l'extérieur la partie ayant la même couleur que le fond ou celle qui a une couleur contrastante, pour visualiser un segment de chiffre ou un symbole en général. Un battement de fin de course facilite le placement des rouleaux, qui pivotent avec un certain frottement pour éviter tout déplacement accidentel.

Le dispositif, du fait qu'il ne demande pas d'alimentation électrique, est particulièrement indiqué pour une utilisation mobile, pour faire des communications au cours de manifestations sportives; il peut également être utile dans toute autre application appropriée.

FIG.1

Dispositif pour la composition et pour la visualisation de chiffres qui peuvent être formés et effacés à discrétion manuellement et rapidement.

L'invention dont il s'agit concerne un dispositif pour la composition et pour la visualisation de chiffres, qui peuvent être formés et effacés manuellement avec une très grande rapidité. Le dispositif, maniable, solide et d'un emploi aisé, est particulièrement indiqué pour une utilisation mobile au cours de manifestations sportives et autres choses de ce genre dans le but de faire des communications aux concurrents.

Dans presque toutes les manifestations sportives il est nécessaire de fournir au public ou aux concurrents les résultats partiels au finals des différentes épreuves. Lorsque les données ont une certaine complexité, l'on se sert de panneaux électroniques, qui peuvent être mis à jour continuellement et rapidement de loin. Dans les cas les plus simples ou au cours de manifestations sportives n'ayant pas une grande importance on emploie en général des tableaux sur lesquels l'on écrit manuellement, comme par exemple dans les compétitions automobiles ou de motocyclettes, au cours desquelles les assistants techniciens montrent à chaque concurrent, tour après tour, un écriteau qui indique la position et l'écart.

Les nombres écrits à la main, à cause de la hâte et de l'excitation provoquées par la course, ne sont pas toujours nets et parfois on peut difficilement les lire de loin. D'autre part, un panneau électronique lumineux n'est pas facilement visible en plein jour à l'extérieur; il peut avoir une complexité qui n'est pas proportionnée aux données, peu nombreuses, devant être transmises et il est excessivement délicat pour une utilisation mobile dans des endroits équipés de façon provisoire.

L'invention dont il s'agit comple une lacune dans les dispositifs de signalisation visuelle. Elle concerne en effet un dispositif pour visualiser des chiffres, qui peuvent être formés et effacés à discrétion manuellement et rapidement. Elle est constituées par un panneau comprenant des rouleaux disposés de façon adéquate; chaque rouleau est divisé longitudinalement en deux parties d'une couleur différente et contrastante. Une des deux parties a la même couleur que le panneau de fond. Chaque rouleau on peut le tourner manuellement; il peut prendre deux positions, de manière à présenter vers l'extérieur la partie ayant la même couleur que le fond ou celle qui a une couleur différente, pour visualiser un segment de chiffre.

Ce dispositif est particulièrement indiqué pour une utilisation mobile, même par du personnel non exercé; en effet il ne demande pas d'alimentation électrique, il est maniable, solide, d'un emploi aisé et il est à même de fournir des indications parfaitement visibles de loin. Ce dispositif pourrait même être employé dans d'autres domaines; il pourrait par exemple être utilisé pour former l'horaire d'ouverture et de fermeture de magasins, les numéros de ligne des autobus ou pour toute autre application appropriée.

- 3 -

L'invention est exposée ci-dessous plus en détail, avec l'aide de dessins qui représentent seulement des façon d'exécution.

L'illustration n° 1 montre la vue antérieure du dispositif, placé de façon à fournir l'indication "3 - 12".

L'illustration n° 2 représente une vue latérale qui met en évidence le profil extrêmement plat et par conséquent la très grande maniabilité du dispositif.

Les illustrations n° 3 et n° 4 représentent respectivement la section transversale et la section longitudinale d'un siège de logement des rouleaux utilisés pour former les chiffres, avec le rouleau correspondant tourné de façon à présenter vers l'extérieur la surface dont la couleur contraste avec celle du fond.

Les illustrations n° 5 et n° 6 représentent les mêmes détails que les illustrations n° 3 et n° 4, mais avec le rouleau tourné de façon à présenter vers l'extérieur la surface ayant la même couleur que le fond.

L'illustration n° 7 représente en perspective une possible modification de construction d'un rouleau avec le correspondant siège de logement.

L'Illustration n° 8 représente une section longitudinale du rouleau de l'illustration précédente, introduit dans son logement.

Dans les illustrations n° 1, 2, 3, 4, 5 et 6 par "1" l'on indique le panneau dans lequel se trouvent, dans une position adéquate, les sièges "2". Dans les sièges "2" sont introduits à pression des éléments cylindriques "3", munis aux deux extrémités de tourillons en pointe "4", qui permettent aux éléments mêmes de pivoter sur leur axe. La rotation devra avoir lieu avec un certain frottement, pour éviter tout déplacement dû à des causes accidentelles. Chaque élément cylindrique "3", qui constituè un segment de chiffre, présente une surface divisée longitudinalement en deux parties d'une couleur différente: une moitié a la même couleur que le panneau "1", tandis que l'autre moitié a une couleur qui contraste.

Les éléments "3" sont placés manuellement, de façon à présenter vers l'extérieur la surface dont la couleur contraste avec celle du fond, comme dans les illustrations "3" et "4", ou celle qui a la même couleur que le fond, comme dans les illustrations "5" et "6", suivant que l'on veut ou non mettre en évidence le segment de chiffre correspondant. Dans les deux cas, le placement exact de chaque rouleau est assuré par le goujon "5" des illustrations n° 3, 4 et 5, qui heurtera, d'un côte ou de l'autre, contre la surface postérieure du panneau "1".

Par "6" on indique un panneau de fermeture espacé d'une manière adéquate du panneau "1", de façon à ne pas gêner la rotation des rouleaux qui constituent les segments des chiffres. Ce panneau constitue une protection qui permet d'éviter toute rotation accidentelle des rouleaux et qui couvre les faces postérieures des chiffres, éliminant ainsi toute possibilité de confusion.

Entre le premier groupe de deux chiffres, qui représente la position du concurrent, et le deuxième groupe de deux chiffres, qui indique l'avance ou le retard en secondes, on a prévu la composition du signe "+" en cas d'avance et du signe "-" en cas de retard. Pour ces symboles, du fait que les deux segments sont croisés, l'on a utilisé un élément cylindrique "7" et des rouleaux "8" ayant une longueur inférieure, placés suivant l'illustration n° 1. La surface de ces éléments aussi est divisée en deux parties qui ont une couleur différente et contrastante.

Par "9", illustration n° 1, l'on indique un rouleau pour représenter la virgule ou le point et par "10" un autre rouleau pour représenter l'apostrophe.

Le rouleau "7" pourrait même être remplacé par un signe d'une forme correspondante, imprimé directement sur le panneau "1."

Pour mettre le tableau rapidement au zéro l'on peut passer la main sur les rouleaux se trouvant en parallèle, horizontalement et verticalement.

Par "11", illustrations 1 e 2, l'on indique une poignée pour faciliter le maniement du tableau. Par "12" et par "13" l'on indique des glissières qui permettent l'assemblage de plusieurs tableaux ou éventuellement de panneaux portant des inscriptions explicatives.

Dans la modification sur la table II, les goujons "14" des rouleaux sont réalisés directement dans les sièges de logement du panneau"1" Chaque rouleau est constitué par deux parties "15" et "16" que l'on peut assembler et qui ont une couleur différente et contrastante; après avoir été introduites dans le siège "2" elles peuvent être assemblées par des goujons "17" et éventuellement par de l'adhésif. Dans les deux parties "15" et "16" l'on a prévu des sièges "18" pour le passage des goujons "14".

Par "19" l'on a indiqué des lamelles qui frottent sur les extrémités des goujons "14", comme il apparaît évident dans la illustration 8, pour créer une friction propre à empêcher tout déplacement accidentel du rouleau. Par "20", illustration 7, l'on indique le battement de placement du rouleau.

Le dispositif qui a été décrit peut avoir un nombre de chiffres quelconque et il peut être construit en matière plastique ou en toute autre matière appropriée. La fixation des segments à rouleau, les battements correspondants de fin de course et les détails de construction en général peuvent être même différents de ceux qui ont été illustrés à titre d'exemple; ils ne peuvent toutefois sortir du domaine de cette invention.

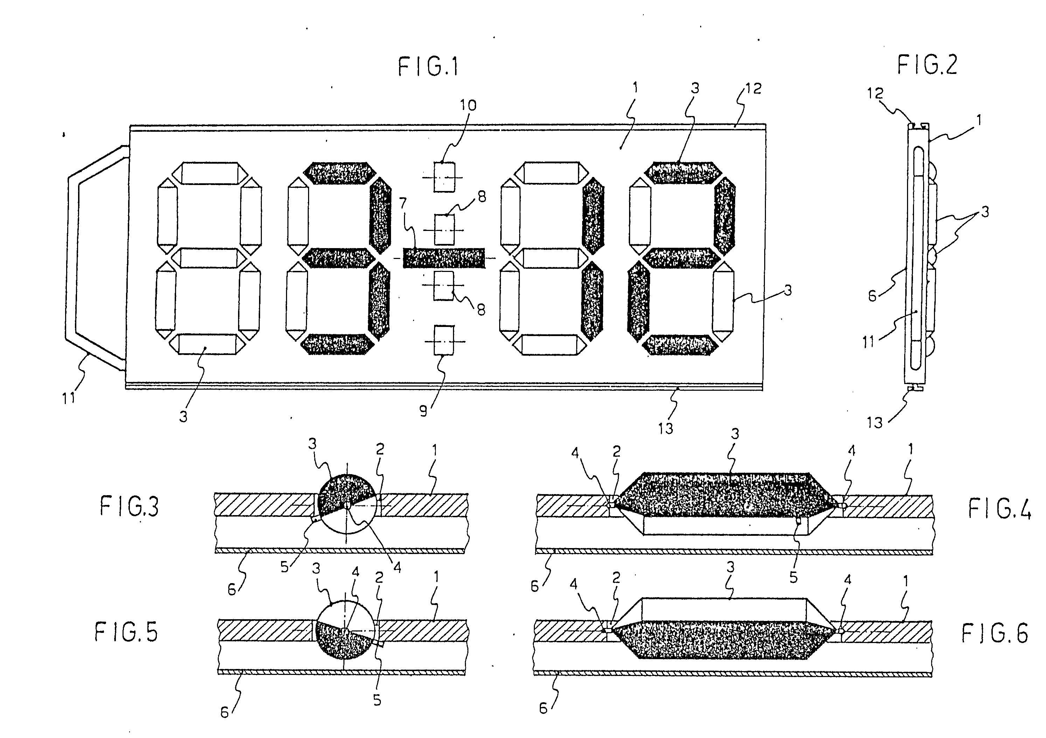

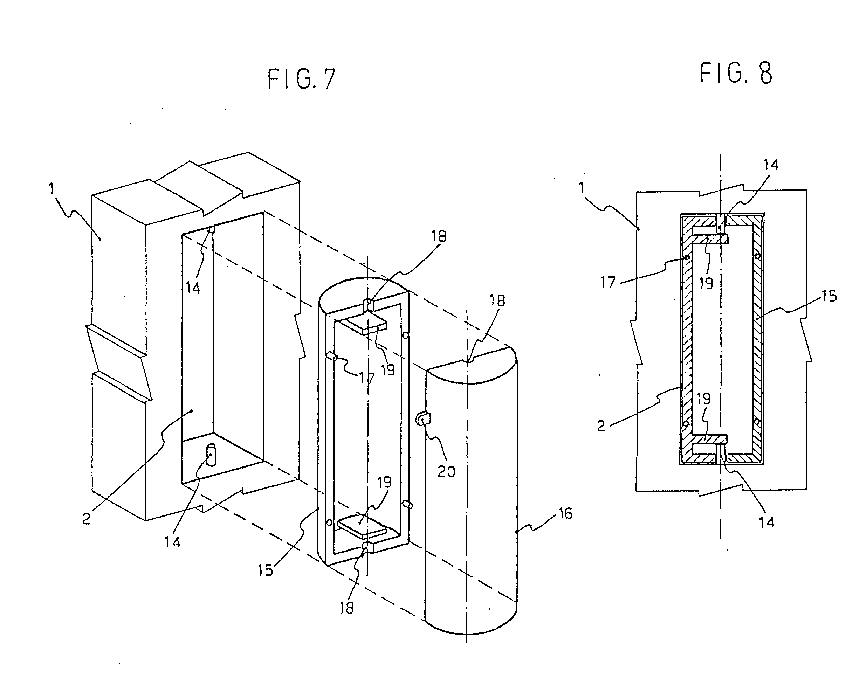

Revendications

1. Dispositif pour la composition et pour la visualisation de chiffres qui peuvent être formés et effacés à discrétion manuellement et rapidement; il est formé par un panneau présentant des sièges pour le logement de rouleaux placés de façon à constituer des éléments de chiffre ou des symboles en général, caractérisé en ce que chaque rouleau est divisé longitudinalement en deux parties, dont l'une a la même couleur que le panneau et l'autre une couleur contrastante, et on peut le faire pivoter, par l'effleurement d'une main, pour présenter à l'extérieur la surface ayant la même couleur que le fond ou celle dont la couleur est contrastante, suivant le chiffre ou le symbole que l'on veut former.

2. Dispositif tout comme à la première revendication, caractérisé en ce que les rouleaux peuvent pivoter axialement et que ils ont un battement de fin de course qui leur permet d'avoir une position parfaite quelle que soit la surface tournée vers l'extérieur, par un simple et rapide mouvement d'effleurement de la main.

3. Dispositif tout comme dans les revendications n° 1 et 2, caractérisé en ce que les rouleaux pivotent de façon à provoquer un certain frottement, pour éviter tout déplacement accidentel.

4. Dispositif tout comme dans les revendications n° 1, 2 et 3, caractérisé par l'existence d'un panneau de fermeture postérieur pour couvrir le dessous des chiffres, de façon à éviter toute possibilité de confusion et de déplacement accidentel des rouleaux.

5. Dispositif tout comme dans les revendications n° 1, 2, 3 et 4, caractérisé par l'existence de glissières pour l'assemblage d'autres panneaux exactement pareils ou de panneaux portant des inscriptions de commentaire.

FIG.1

FIG.2

FIG.3

FIG.4

FIG.5

FIG.6

0031033

FIG. 7

FIG. 8

Office européen
des brevets

**RAPPORT DE RECHERCHE EUROPEENNE**

Numéro de la demande
EP 80 10 7167

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendica- tion concernée | |
| | US - A - 1 609 989 (R.N. CHUBB)  * Page 1, ligne 93 - page 2, ligne 113; figures 1-6 *  -- | 1,2,4 | G 09 F 9/37// A 63 B 71/06 |
| | FR - A - 2 335 128 (BURKE COLE PULLMAN)  * Revendications 1,2,9; figures 1-3 *  -- | 1,3 | |
| | US - A - 3 410 011 (RICHARD G. BOWMAN)  * Revendication 1; colonne 4, lignes 28-63; figures 5-7 *  -- | 1,4 | **DOMAINES TECHNIQUES RECHERCHES** (Int. Cl. 3)  G 09 F 9/37 9/30 A 63 B 71/06 |
| A | US - A - 3 740 878 (DISPLAY CORP. INTERNATIONAL)  * Revendications 1,2; colonne 2, ligne 41 - colonne 3, ligne 20; figures 1,2 *  ----- | 1 | |

CATEGORIE DES DOCUMENTS CITES

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

| | | | |
|---|---|---|---|
| Le présent rapport de recherche a été établi pour toutes les revendications | | | |
| Lieu de la recherche La Haye | Date d'achèvement de la recherche 20-03-1981 | Examinateur FRANSEN | |

OEB Form 1503.1  06.78